# EUROPEAN PATENT APPLICATION

(11) **EP 1 475 888 A1**
(43) Date of publication of application: **10.11.2004**
(21) Application number: 04009713.1
(22) Date of filing: 23.04.2004
(51) Int. Cl.: H03H 7/01

(54) **Chebyshev high-pass filter having steep falling edge**

(30) Priority: 28.04.2003 JP 2003123818
(71) Applicant: ALPS ELECTRIC CO., LTD., Tokyo 145-8501 (JP)
(72) Inventor: Aoyagi, Toru c/o Alps Electric Co., Ltd., Ota-ku Tokyo, 145-8501 (JP)
(74) Representative: Klunker . Schmitt-Nilson . Hirsch

(57) **Abstract**

A Chebyshev high-pass filter includes at least two double π-shaped filter stages (3,4) that are cascaded to each other, each including a first inductor (2a), first capacitor (2b), second inductor (2c), third inductor (2d), second capacitor (2c), and fourth inductor (2f); and at least one additional capacitor (3). In the double π-shaped filter stage, the first inductor shunt-connected to a signal line, the first capacitor connected in series to the signal line, and the second inductor shunt-connected to the signal line are connected in this order, and a serially-connected circuit including the third inductor, the second capacitor, and the fourth inductor is connected in parallel to the first capacitor. The additional capacitor is connected between the connection point between the second capacitor and the fourth inductor in an upstream double π-shaped filter stage and the connection point between the third inductor and the second capacitor in an adjacent downstream double π-shaped filter stage.

## Description

### BACKGROUND OF THE INVENTION

### 1. Field of the Invention

The present invention relates to Chebyshev high-pass filters. More particularly, the present invention relates to a Chebyshev high-pass filter including at least two cascaded double π-shaped filter stages and having a steep falling edge at the boundary between a transmission frequency band and an attenuation frequency band due to the connection of at least one additional capacitor.

### 2. Description of the Related Art

Heretofore, Chebyshev high-pass filters, each including two or more cascaded filter stages, have been used. The increased number of the used filter stages produces a steep falling edge at the boundary between a transmission frequency band and an attenuation frequency band of the Chebyshev high-pass filter and improves the attenuation characteristics in the attenuation frequency band.

Two known structures are adopted in the filter stages used in the Chebyshev high-pass filter; that is, a structure in which a first inductor shunt-connected to a signal line; a parallel-connected circuit including a first capacitor and a third inductor, the parallel-connected circuit being connected in series to the signal line; and a second inductor shunt-connected to the signal line are connected in this order (this structure of the filter stages is hereinafter referred to as a π-shaped filter stage), and a structure in which a first inductor shunt-connected to a signal line, a first capacitor connected in series to the signal line, and a second inductor shunt-connected to the signal line are connected in this order, and a serially-connected circuit including a second capacitor, a third inductor, and a third capacitor is connected in parallel to the first capacitor (this structure of the filter stages is hereinafter referred to as a double π-shaped filter stage).

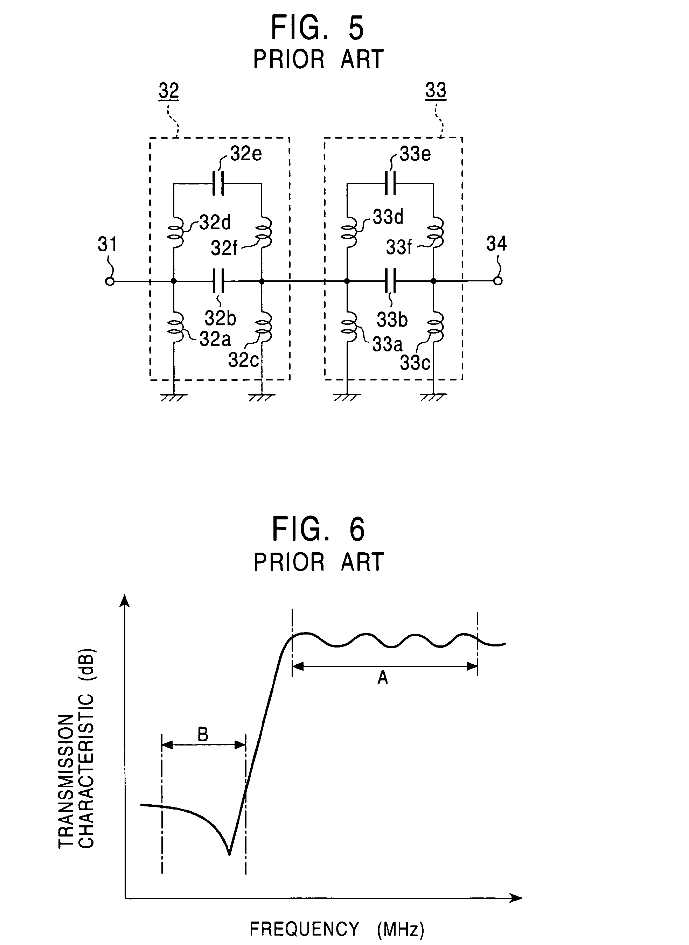

Fig. 5 is a circuit diagram showing the structure of the main part of a known Chebyshev high-pass filter including two cascaded double π-shaped filter stages.

Referring to Fig. 5, the known Chebyshev high-pass filter has a signal input terminal 31, an upstream double π-shaped filter stage 32, a downstream double π-shaped filter stage 33, and a signal output terminal 34. The upstream double π-shaped filter stage 32 and the downstream double π-shaped filter stage 33 are cascaded between the signal input terminal 31 and the signal output terminal 34.

The upstream double π-shaped filter stage 32 includes a first inductor 32a, a first capacitor 32b, a second inductor 32c, a third inductor 32d, a second capacitor 32e, and a fourth inductor 32f. These components from 32a to 32f are connected to each other, as shown in Fig. 5.

The downstream double π-shaped filter stage 33, which has the same structure as the upstream double π-shaped filter stage 32, includes a first inductor 33a, a first capacitor 33b, a second inductor 33c, a third inductor 33d, a second capacitor 33e, and a fourth inductor 33f. These components from 33a to 33f are connected to each other, as shown in Fig. 5.

Fig. 6 is a characteristic diagram showing the transmission frequency band and the attenuation frequency band of the Chebyshev high-pass filter in Fig. 5.

Referring to Fig. 6, the horizontal axis denotes frequency (MHz) and the vertical axis denotes transmission characteristic (dB). The transmission frequency band is represented by A and the attenuation frequency band is represented by B.

As shown in the characteristic diagram in Fig. 6, the Chebyshev high-pass filter has a relatively steep falling edge at the boundary between the transmission frequency band A and the attenuation frequency band B. In addition, the transmission frequency band A has a wavy characteristic and the attenuation frequency band B has an attenuation peak.

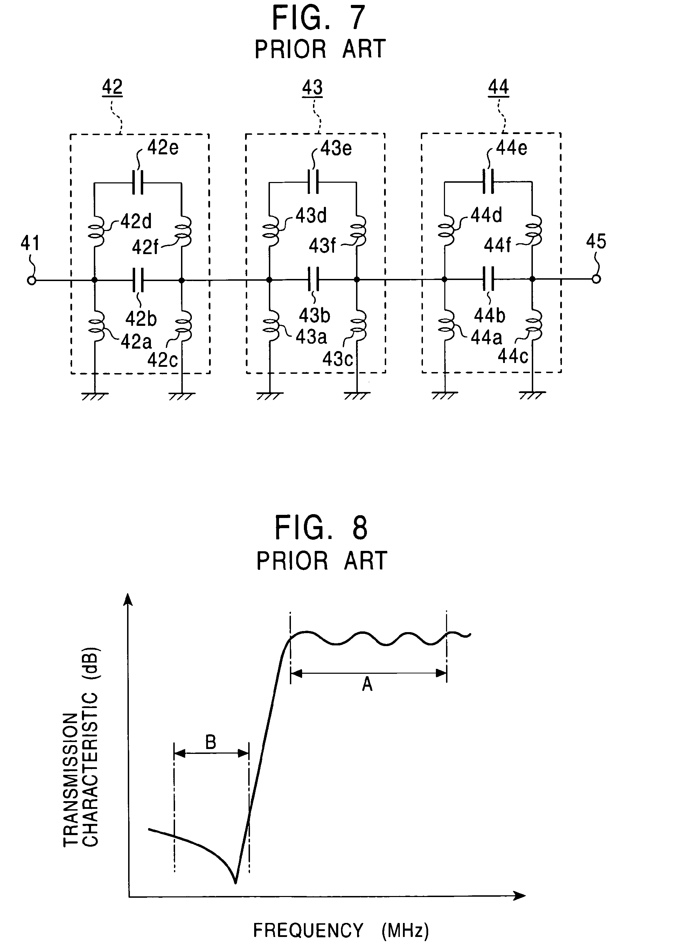

Fig. 7 is a circuit diagram showing the structure of the main part of another known Chebyshev high-pass filter including three cascaded double π-shaped filter stages.

Referring to Fig. 7, the Chebyshev high-pass filter has a signal input terminal 41, an upstream double π-shaped filter stage 42, an intermediate double π-shaped filter stage 43, a downstream double π-shaped filter stage 44, and a signal output terminal 45. The upstream double π-shaped filter stage 42, the intermediate double π-shaped filter stage 43, and the downstream double π-shaped filter stage 44 are cascaded between the signal input terminal 41 and the signal output terminal 45.

The upstream double π-shaped filter stage 42 includes a first inductor 42a, a first capacitor 42b, a second inductor 42c, a third inductor 42d, a second capacitor 42e, and a fourth inductor 42f. These components from 42a to 42f are connected to each other, as shown in Fig. 7.

The intermediate double π-shaped filter stage 43, which has the same structure as the upstream double π-shaped filter stage 42, includes a first inductor 43a, a first capacitor 43b, a second inductor 43c, a third inductor 43d, a second capacitor 43e, and a fourth inductor 43f. These components from 43a to 43f are connected to each other, as shown in Fig. 7.

The downstream double π-shaped filter stage 44, which has the same structure as the upstream double π-shaped filter stage 42 and the intermediate double π-shaped filter stage 43, includes a first inductor 44a, a first capacitor 44b, a second inductor 44c, a third inductor 44d, a second capacitor 44e, and a fourth inductor 44f. These components from 44a to 44f are connected to each other, as shown in Fig. 7.

Fig. 8 is a characteristic diagram showing the transmission frequency band and the attenuation frequency band of the Chebyshev high-pass filter in Fig. 7.

Referring to Fig. 8, the horizontal axis denotes frequency (MHz) and the vertical axis denotes transmission characteristic (dB). The transmission frequency band is represented by A and the attenuation frequency band is represented by B.

As shown in the characteristic diagram in Fig. 8, the Chebyshev high-pass filter has a steeper falling edge at the boundary between the transmission frequency band A and the attenuation frequency band B, compared with the Chebyshev high-pass filter shown in Fig. 5. In addition, the transmission frequency band A has a wavy characteristic, and the attenuation frequency band B has a sharper attenuation peak, compared with the attenuation peak of the Chebyshev high-pass filter shown in Fig. 5.

Chebyshev high-pass filters using known double π-shaped filter stages each have a steeper falling edge at the boundary between the transmission frequency band A and the attenuation frequency band B, compared with Chebyshev high-pass filters using known π-shaped filter stages, when the number of the used filter stages are the same. The Chebyshev high-pass filters using known double π-shaped filter stages effectively functions when the transmission frequency band A is near the attenuation frequency band B.

Since multiple frequency bands have been used in various applications in recent years and the transmission frequency band A has increasingly come closer to the attenuation frequency band B, a steep falling edge at the boundary between the transmission frequency band A and the attenuation frequency band B is indispensable in the Chebyshev high-pass filters. The number of the used double π-shaped filter stages consequentially tends to increase in the Chebyshev high-pass filters using the double π-shaped filter stages.

Increasing the number of filter stages, particularly, the number of the double π-shaped filter stages, used in the Chebyshev high-pass filter can produce a falling edge having a required steepness at the boundary between the transmission frequency band A and the attenuation frequency band B. However, owing to the increased number of the double π-shaped filter stages, the number of components required for the Chebyshev high-pass filter is largely increased, thus disadvantageously suppressing the reduction in size of the Chebyshev high-pass filter and increasing the manufacturing cost.

### SUMMARY OF THE INVENTION

Accordingly, it is an object of the present invention to provide a Chebyshev high-pass filter that has a falling edge having a desired steepness at the boundary between a transmission frequency band and an attenuation frequency band by adopting a simple structure without increasing the number of double π-shaped filter stages.

A Chebyshev high-pass filter of the present invention includes at least two double π-shaped filter stages that are cascaded to each other, each including a first inductor, a first capacitor, a second inductor, a third inductor, a second capacitor, and a fourth inductor; and at least one additional capacitor. In the double π-shaped filter stage, the first inductor shunt-connected to a signal line, the first capacitor connected in series to the signal line, and the second inductor shunt-connected to the signal line are connected in this order, and a serially-connected circuit including the third inductor, the second capacitor, and the fourth inductor is connected in parallel to the first capacitor. The additional capacitor is connected between the connection point between the second capacitor and the fourth inductor in an upstream double π-shaped filter stage, among the cascaded double π-shaped filter stages, and the connection point between the third inductor and the second capacitor in an adjacent downstream double π-shaped filter stage.

In the Chebyshev high-pass filter having the multiple cascaded double π-shaped filter stages, connecting an additional capacitor between the connection point between the second capacitor and the fourth inductor in the upstream double π-shaped filter stage and the connection point between the third inductor and the second capacitor in the adjacent downstream double π-shaped filter stage and selecting the capacitance of the additional capacitor can produce a falling edge having a desired steepness at the boundary between the transmission frequency band and the attenuation frequency band.

It is sufficient to only connect the additional capacitor, without increasing the number of the cascaded double π-shaped filter stages, in order to produce a steep falling edge at the boundary between the transmission frequency band and the attenuation frequency band. Accordingly, the increase in the number of components can be suppressed, so that the reduction in size of the Chebyshev high-pass filter can be achieved and the increase in the manufacturing cost can also be suppressed.

### BRIEF DESCRIPTION OF THE DRAWINGS

Fig. 1 is a circuit diagram showing the structure of the main part of a Chebyshev high-pass filter, according to a first embodiment of the present invention, including two cascaded double π-shaped filter stages;
Fig. 2 is a characteristic diagram showing a transmission frequency band and an attenuation frequency band of the Chebyshev high-pass filter of the first embodiment;
Fig. 3 is a circuit diagram showing the structure of the main part of a Chebyshev high-pass filter, according to a second embodiment of the present invention, including three cascaded double π-shaped filter stages;
Fig. 4 is a characteristic diagram showing the transmission frequency band and the attenuation frequency band of the Chebyshev high-pass filter of the second embodiment;
Fig. 5 is a circuit diagram showing the structure of the main part of a known Chebyshev high-pass filter including two cascaded double π-shaped filter stages;
Fig. 6 is a characteristic diagram showing the transmission frequency band and the attenuation frequency band of the Chebyshev high-pass filter in Fig. 5;
Fig. 7 is a circuit diagram showing the structure of the main part of another known Chebyshev high-pass filter including three cascaded double π-shaped filter stages; and
Fig. 8 is a characteristic diagram showing the transmission frequency band and the attenuation frequency band of the Chebyshev high-pass filter in Fig. 7.

### DESCRIPTION OF THE PREFERRED EMBODIMENTS

Embodiments of the present invention will now be described with reference to the attached drawings.

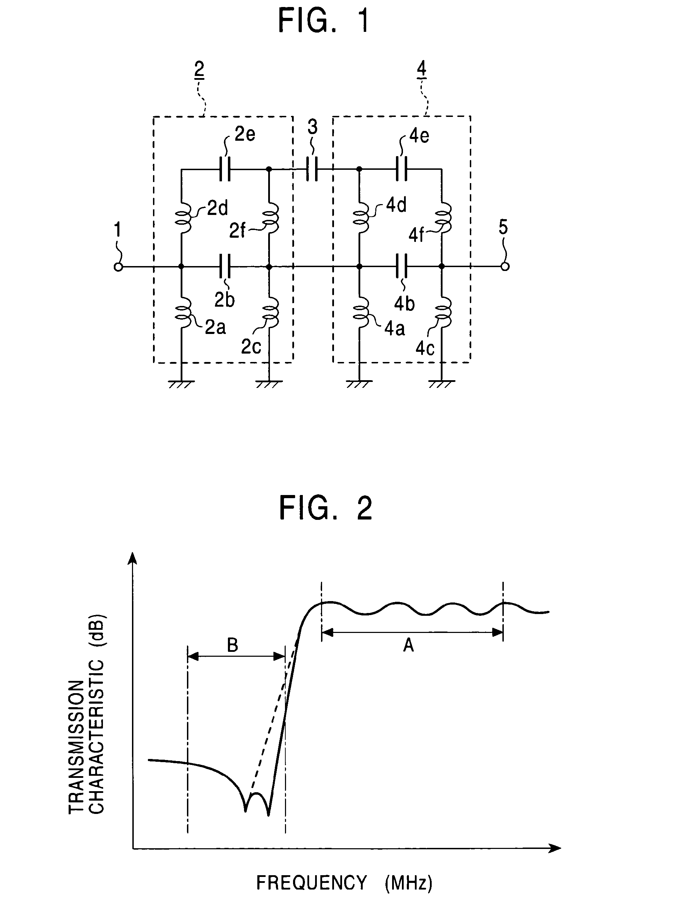

Fig. 1 is a circuit diagram showing the structure of the main part of a Chebyshev high-pass filter, according to a first embodiment of the present invention, including two cascaded double π-shaped filter stages.

Referring to Fig. 1, the Chebyshev high-pass filter of the first embodiment has a signal input terminal 1, an upstream double π-shaped filter stage 2, an additional capacitor 3, a downstream double π-shaped filter stage 4, and a signal output terminal 5.

The upstream double π-shaped filter stage 2 includes a first inductor 2a, a first capacitor 2b, a second inductor 2c, a third inductor 2d, a second capacitor 2e, and a fourth inductor 2f. The downstream double π-shaped filter stage 4 includes a first inductor 4a, a first capacitor 4b, a second inductor 4c, a third inductor 4d, a second capacitor 4e, and a fourth inductor 4f.

In the upstream double π-shaped filter stage 2, one end of the first inductor 2a is connected to the signal input terminal 1, one end of the first capacitor 2b, and one end of the third inductor 2d, and the other end of the first inductor 2a is grounded. One end of the second inductor 2c is connected to the other end of the first capacitor 2b and one end of the fourth inductor 2f, and the other end of the second inductor 2c is grounded. One end of the second capacitor 2e is connected to the other end of the third inductor 2d, and the other end of the second capacitor 2e is connected to the other end of the fourth inductor 2f.

In the downstream double π-shaped filter stage 4, one end of the first inductor 4a is connected to one end of the second inductor 2c in the upstream double π-shaped filter stage 2 and also connected to one end of the first capacitor 4b and one end of the third inductor 4d, and the other end of the first inductor 4a is grounded. One end of the second inductor 4c is connected to the signal output terminal 5, the other end of the first capacitor 4b, and one end of the fourth inductor 4f, and the other end of the second inductor 4c is grounded. One end of the second capacitor 4e is connected to the other end of the third inductor 4d, and the other end of the second capacitor 4e is connected to the other end of the fourth inductor 4f.

One end of the additional capacitor 3 is connected to the connection point between the second capacitor 2e and the fourth inductor 2f in the upstream double π-shaped filter stage 2, and the other end of the additional capacitor 3 is connected to the connection point between the third inductor 4d and the second capacitor 4e in the downstream double π-shaped filter stage 4. The capacitance of the additional capacitor 3 is determined so as to produce a steep falling edge at the boundary between a transmission frequency band and an attenuation frequency band when the additional capacitor 3 is connected to the Chebyshev high-pass filter.

Fig. 2 is a characteristic diagram showing the transmission frequency band and the attenuation frequency band of the Chebyshev high-pass filter of the first embodiment.

Referring to Fig. 2, the horizontal axis denotes frequency (MHz) and the vertical axis denotes transmission characteristic (dB). The transmission frequency band is represented by A and the attenuation frequency band is represented by B.

A solid line in Fig. 2 represents the characteristic of the Chebyshev high-pass filter of the first embodiment. A broken line represents the characteristic of a known Chebyshev high-pass filter of this type, for comparison, without the additional capacitor 3 being connected.

As shown in the characteristics represented by the solid line and broken line in Fig. 2, the Chebyshev high-pass filter of the first embodiment has a steeper falling edge at the boundary between the transmission frequency band A and the attenuation frequency band B, as compared with the characteristic of the known Chebyshev high-pass filter of this type. In addition, a new attenuation peak is produced near the transmission frequency band A.

As described above, according to the Chebyshev high-pass filter of the first embodiment, connecting only the additional capacitor 3 to the Chebyshev high-pass filter without a new double π-shaped filter stage can produce a steep falling edge at the boundary between the transmission frequency band A and the attenuation frequency band B, thus minimizing an increase in the number of components in the Chebyshev high-pass filter and reducing the size of the Chebyshev high-pass filter.

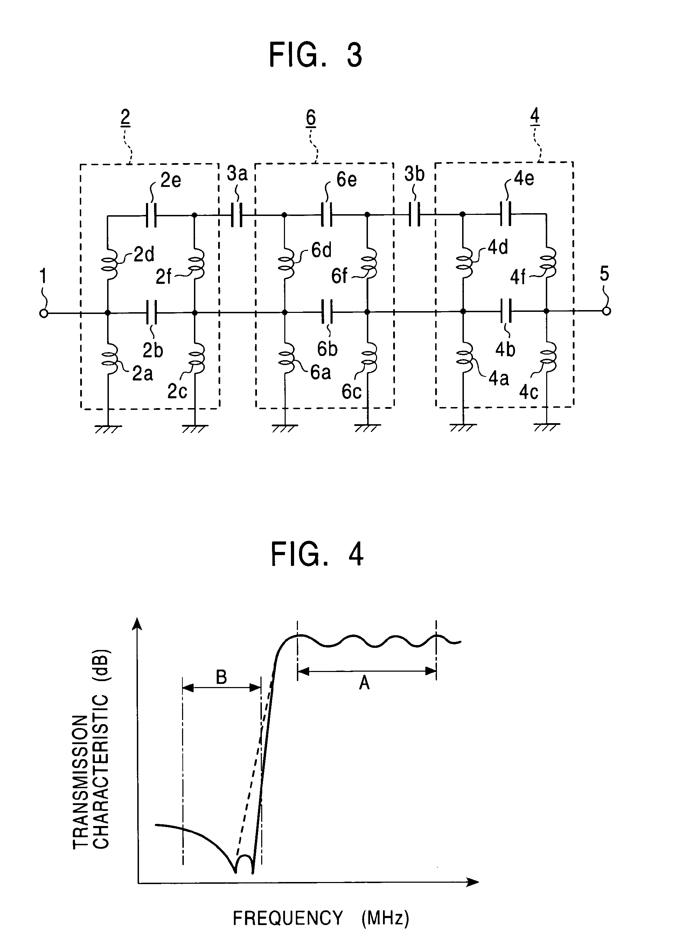

Fig. 3 is a circuit diagram showing the structure of the main part of a Chebyshev high-pass filter, according to a second embodiment of the present invention, including three cascaded double π-shaped filter stages.

Referring to Fig. 3, the Chebyshev high-pass filter of the second embodiment has a signal input terminal 1, an upstream double π-shaped filter stage 2, a first additional capacitor 3a, an intermediate double π-shaped filter stage 6, a second additional capacitor 3b, a downstream double π-shaped filter stage 4, and a signal output terminal 5.

The upstream double π-shaped filter stage 2 and the downstream double π-shaped filter stage 4 in the Chebyshev high-pass filter of the second embodiment has the same structure as the upstream double π-shaped filter stage 2 and the downstream double π-shaped filter stage 4 in the Chebyshev high-pass filter of the first embodiment. The intermediate double π-shaped filter stage 6, which has the same structure as the upstream double π-shaped filter stage 2 or the downstream double π-shaped filter stage 4, includes a first inductor 6a, a first capacitor 6b, a second inductor 6c, a third inductor 6d, a second capacitor 6e, and a fourth inductor 6f.

In the intermediate double π-shaped filter stage 6, one end of the first inductor 6a is connected to one end of the second inductor 2c in the upstream double π-shaped filter stage 2 and also is connected to one end of the first capacitor 6b and one end of the third inductor 6d, and the other end of the first inductor 6a is grounded. One end of the second inductor 6c is connected to one end of the first inductor 4a in the downstream double π-shaped filter stage 4, the other end of the first capacitor 6b, and one end of the fourth inductor 6f, and the other end of the second inductor 6c is grounded. One end of the second capacitor 6e is connected to the other end of the third inductor 6d, and the other end of the second capacitor 6e is connected to the other end of the fourth inductor 6f.

One end of the first additional capacitor 3a is connected to the connection point between the second capacitor 2e and the fourth inductor 2f in the upstream double π-shaped filter stage 2, and the other end of the first additional capacitor 3a is connected to the connection point between the third inductor 6d and the second capacitor 6e in the intermediate double π-shaped filter stage 6. One end of the second additional capacitor 3b is connected to the connection point between the second capacitor 6e and the fourth inductor 6f in the intermediate double π-shaped filter stage 6, and the other end of the second additional capacitor 3b is connected to the connection point between the third inductor 4d and the second capacitor 4e in the downstream double π-shaped filter stage 4. The capacitance of each of the first additional capacitor 3a and the second additional capacitor 3b is determined so as to produce a steep falling edge at the boundary between the transmission frequency band and the attenuation frequency band when the first additional capacitor 3a and the second additional capacitor 3b are connected to the Chebyshev high-pass filter.

Fig. 4 is a characteristic diagram showing the transmission frequency band and the attenuation frequency band of the Chebyshev high-pass filter of the second embodiment.

Referring to Fig. 4, the horizontal axis denotes frequency (MHz) and the vertical axis denotes transmission characteristic (dB). The transmission frequency band is represented by A and the attenuation frequency band is represented by B.

A solid line in Fig. 4 represents the characteristic of the Chebyshev high-pass filter of the second embodiment. A broken line represents the characteristic of a known Chebyshev high-pass filter of this type, for comparison, without the first additional capacitor 3a and the second additional capacitor 3b being connected.

As shown in the characteristics represented by the solid line and broken line in Fig. 4, the Chebyshev high-pass filter of the second embodiment has a steeper falling edge at the boundary between the transmission frequency band A and the attenuation frequency band B, as compared with the characteristic of the known Chebyshev high-pass filter of this type. In addition, a new attenuation peak is produced near the transmission frequency band A.

As described above, according to the Chebyshev high-pass filter of the second embodiment, connecting only the first additional capacitor 3a and the second additional capacitor 3b to the Chebyshev high-pass filter without a new double π-shaped filter stage can produce a steep falling edge at the boundary between the transmission frequency band A and the attenuation frequency band B, thus minimizing an increase in the number of components in the Chebyshev high-pass filter and reducing the size of the Chebyshev high-pass filter.

Although the Chebyshev high-pass filter including the two double π-shaped filter stages; that is, the upstream double π-shaped filter stage 2 and the downstream double π-shaped filter stage 4, and the Chebyshev high-pass filter including the three double π-shaped filter stages; that is, the upstream double π-shaped filter stage 2, the downstream double π-shaped filter stage 4, and the intermediate double π-shaped filter stage 6 are described in the above embodiments, the number of the double π-shaped filter stages in the Chebyshev high-pass filter of the present invention is not limited to two or three. The Chebyshev high-pass filter including four or more double π-shaped filter stages performs the same function as in the Chebyshev high-pass filter described above. However, as the number of the double π-shaped filter stages is increased, the number of the connected additional capacitors is increased. When the number of the double π-shaped filter stages is n, the number of the connected additional capacitor is (n-1).

## Claims

1. A Chebyshev high-pass filter comprising:
at least two double π-shaped filter stages that are cascaded to each other, each including a first inductor, a first capacitor, a second inductor, a third inductor, a second capacitor, and a fourth inductor; and
at least one additional capacitor,
wherein, in the double π-shaped filter stage, the first inductor shunt-connected to a signal line, the first capacitor connected in series to the signal line, and the second inductor shunt-connected to the signal line are connected in this order, and a serially-connected circuit including the third inductor, the second capacitor, and the fourth inductor is connected in parallel to the first capacitor, and
wherein the additional capacitor is connected between the connection point between the second capacitor and the fourth inductor in an upstream double π-shaped filter stage, among the cascaded double π-shaped filter stages, and the connection point between the third inductor and the second capacitor in an adjacent downstream double π-shaped filter stage.

2. A Chebyshev high-pass filter according to Claim 1,
wherein the capacitance of the additional capacitor is determined so as to produce a steeper falling edge at the boundary between a transmission frequency band and an attenuation frequency band.

3. A Chebyshev high-pass filter according to Claim 1,
wherein two double π-shaped filter stages, that is, the upstream double π-shaped filter stage and the downstream double π-shaped filter stage are cascaded to each other.

4. A Chebyshev high-pass filter according to Claim 1,
wherein three double π-shaped filter stages, that is, the upstream double π-shaped filter stage, an intermediate double π-shaped filter stage, and the downstream double π-shaped filter stage are cascaded to each other.
